# EUROPEAN PATENT SPECIFICATION

(11) **EP 4 090 478 B1**
(45) Date of publication and mention of the grant of the patent: **23.04.2025**
(21) Application number: 21740818.6
(22) Date of filing: 18.01.2021
(51) Int. Cl.: B09C 1/06, H01J 37/32, H05B 6/64, H05H 1/00, H05H 1/46

(54) **PFAS PROCESSING**
PFAS-VERARBEITUNG
TRAITEMENT DE PFAS

(30) Priority: 16.01.2020 AU 2020900116
(43) Date of publication of application: 23.11.2022
(73) Proprietor: AMT Remediation Pty. Ltd., Manuka, ACT 2603 (AU)
(72) Inventor: McLEAN, David William, Wollongong, NSW 2517 (AU)
(74) Representative: Ponchiroli, Simone
(86) International application number: PCT/AU2021/000005
(87) International publication number: WO 2021/142511

(56) References cited:
- CN-A- 1 850 371
- CN-A- 1 850 371
- CN-A- 102 389 892
- CN-A- 102 389 892
- CN-A- 105 312 313
- CN-A- 105 312 313
- CN-A- 110 170 514
- US-A1- 2018 085 800
- US-A1- 2018 085 800
- US-A1- 2019 314 876
- US-A1- 2019 314 876
- ANDERSEN ALAN: "Final Report on the Safety Assessment of Sodium p -Chloro- m -Cresol, p -Chloro- m -Cresol, Chlorothymol, Mixed Cresols, m -Cresol, o -Cresol, p -Cresol, Isopropyl Cresols, Thymol, o -Cymen-5-ol, and Carvacrol1", INTERNATIONAL JOURNAL OF TOXICOLOGY, SAGE PUBLICATIONS, INC., US, vol. 25, no. 1_suppl, 1 January 2006 (2006-01-01), US, pages 29 - 127, XP055839943, ISSN: 1091-5818, DOI: 10.1080/10915810600716653

## Description

### Field of the Invention

This invention relates to processing of per- and poly-fluoroalkyl substances (referred to herein as PFAS). In particular the invention relates to remediation of soils and other substances to separate PFAS and relates to processing PFAS (whether from the remediation system or otherwise) to convert them into safer substances.

### Background

Per- and poly-fluoroalkyl substances are chemical compounds with extremely high stability giving them very useful properties for multiple industrial uses, including firefighting foams ('aqueous film-forming foams" or AFFFs), non-stick cookware, food packaging, insecticides, and waterproof and fire-resistant fabric. AFFFs have been used on fires at many thousands of emergency and training sites worldwide over the past half-century and the foam can seep into soil and groundwater. PFAS is a hazardous contaminant and due to its stability does not break down easily which means it can accumulate in the environment and eventually move far beyond the source site.

The very properties that have made PFAS industrially and commercially very useful lead to persistency, bio-accumulation and, in some cases, toxicity in the environment. For example, the compound PFOS (perfluoro-octane-sulphonic acid) is very chemically inert and resistant to high temperatures and is therefore very useful in firefighting foam. Complete combustion of PFOS requires combustion temperature of at least 1100°C. PFOS can accumulate in birds, fish and other fauna. The substance is toxic. It accumulates in the liver and in the blood and can cross the placenta. Animal studies have shown liver toxicity, effects related to lipid metabolism, reproduction toxicity and immunological effects.

There are many situations requiring PFAS to be removed from contaminated sources such as water, e.g., groundwater proximate to or downstream in the water migration paths from a contaminated site, or from other sources such as soil, rocks, concrete, paving, asphalt, bitumen, tarmac, etc. where PFAS containing substances have been used.

The processing of PFAS however removed from contaminated sources so as to convert them into safer substances has comprised an incinerating process at temperatures over 1000°C. This requires high energy and specialised high temperature incineration apparatus.

Remediation treatments of soil contaminated with PFAS has been based on some different approaches. For example, addition of chemical reagents to soil so as to chemically react with the PFAS is one known approach currently in use. No known process has been developed to the present inventor's knowledge for separating PFAS from concrete, paving, asphalt, bitumen and tarmac.

US 20190314876 discloses remediation of contaminated soil by conductive heating of soil to raise the temperature to 225°C to 440°C, break bands of the PFAS to organic carbon in the soil, and enable vaporisation of PFAS said to boil at temperatures from 76°C to 218°C. The treatment is prolonged from 1-30 days. The PFAS are treated by electro oxidation.

CN 110 170 514 A relates to the field of soil remediation, in particular to a steam coupled microwave heat treatment contaminated soil device.

CN 102 389 892 A discloses a method for treating soil contaminated by organic matter, by using microwave radiation to make polymer organic matter overflow the soil in a gaseous form after steam.

CN 1 850 371 A discloses a method for treating polychlorobiphenyls (PCBs) in polluted soil.

CN 105 312 313 A discloses a catalytic degradation method of petroleum-polluted soils.

US 2018/085800 A1 discloses a soil remediation method for treating contaminated soil.

### Objects of the Invention

It is an object of the present invention to provide method for remediating particulate solids such as soils, concrete, asphalt contaminated with PFAS which can be effective and provide at least a useful alternative to existing remediation processes.

### Summary of Invention

According to a first aspect of the present invention there is provided a method according to claim 1. Further aspects of the invention are defined in the dependent claims.

The expression "safer substances" used herein, including in the claims, is to be interpreted to encompass not only substances which are less toxic than PFAS but also substances which can be more readily further processed (chemically, thermally, physically or otherwise) than PFAS, e.g. by further processing by condensation, chemical reaction, adsorption, filtration, pyrolysis, incineration or thermal treatment.

Preferably the PFAS are continuously introduced into the treatment zone and dissociation products are continuously withdrawn therefrom with the flow rate and plasma temperature being sufficient to effect substantially complete conversion of the PFAS into safer substances.

The microwave radiation is generated by a microwave generator and a waveguide transfers the microwave radiation to the treatment zone through a microwave transparent wall of, or window in, the treatment zone. The waveguide preferably incorporates a tuner operative to match impedance of the microwave generator and associated waveguide to the impedance of the load consisting of the PFAS (and carries gas or vapour) in the treatment zone so as to thereby improve microwave energy transfer efficiency to the treatment zone and improve the plasma creation.

According to the invention there is provided a method for remediating particulate solids contaminated with PFAS, the method including the steps of: locating a body of particulate solids contaminated with PFAS in a closed vessel, generating microwave radiation of pre-determined frequency or frequencies and power level or levels, directing microwave radiation generated to the body of particulate solids in the vessel so as to heat the particulate solids and promote vaporisation of PFAS, transferring vapour from the vessel to a treatment stage, and treating in the treatment stage the vapour transferred from the vessel so as to at least partially convert the PFAS into safer substances.

In the method according to the second aspect, the step of treating the vapour in the treatment stage preferably comprises exposing the vapour to a plasma within a treatment zone whereby PFAS in the vapour entering and passing through the treatment zone are subject to at least partial dissociation of the PFAS molecules. Preferably the plasma in the treatment zone is created and/or is maintained by directing to the treatment zone microwave radiation from a secondary microwave generator operatively associated with the treatment zone. Thus the PFAS recovered may be treated using the method according to the first aspect of the invention.

The particulate solids contaminated with PFAS and located in the vessel may be mixed either intermittently or continuously during irradiation by the microwave radiation so as to promote heating of the particulate solids and vaporisation of PFAS.

In a first possible embodiment of the method of the second aspect, particulate solids contaminated with PFAS are progressively fed into the vessel, whether by continuous feeding of particulate solids or by intermittent feeding of charges of particulate solids, and heated particulate solids that have yielded up PFAS by vaporisation are progressively removed from the vessel so that the particulate solids progressively move from a soil feed location of the vessel to a soil removal location of the vessel while being exposed to microwave irradiation. In this embodiment, the chamber in which the particulate solids are irradiated may include (or consist of) a microwave transparent wall or window, e.g. composed of quartz or ceramic or other microwave transparent material, through which the particulate solids are exposed to the irradiation. The enclosure preferably comprises a tube into which particulate solids to be treated are fed, the tube being inclined and either continuously or intermittently vibrated and/or rotated so that the particulate solids progressively travel by gravity down the inclined tube to an exit therefrom.

In a second possible embodiment of the method of the second aspect, a batch of particulate solids contaminated with PFAS is located in the closed vessel, and during irradiation by the microwave radiation, the batch is mixed either intermittently or continuously so as to expose the batch of particulate solids substantially throughout its volume to the microwave irradiation for a vaporisation period during which no further particulate solids are added to the vessel. Vapour containing the PFAS yielded up by the batch may be removed from the closed vessel for downstream treatment prior to opening of the vessel and discharge of the treated particulate solids therein.

In both these first and second possible embodiments, the particulate solids may be subject to a two-stage heating process comprising:
a first preheating stage in which the particulate solids are heated to vaporize water in the particulate solids and thereby dry the particulate solids to a pre-determined moisture content, and
a second higher energy heating stage in which microwave irradiation of the particulate solids having the reduced moisture content occurs to promote vaporization of PFAS.

The first preheating stage may comprise or include conventional heating by conduction or thermal (IR) radiation, (including before introduction into the closed vessel), and induction heating by low power microwave may also or alternatively be used. The microwave generator used for the PFAS vaporization second heating stage can be operated at a lower power level for the first preheating stage.

Preferably vapour containing PFAS yielded by the particulate solids is drawn from the vessel during or after the irradiation of the particulate solids in the vessel. The vapour containing PFAS may be continuously drawn from the vessel and transferred into the treatment stage during the treatment of the particulate solids in the vessel by creating a negative pressure downstream of the treatment stage which thereby draws vapours from the vessel into and through the treatment stage.

The method according to the second aspect of the invention may include the further step of creating a partial vacuum where particulate solids heated by the microwave radiation directed into the closed vessel are located so as to promote vaporization of PFAS from the particulate solids. There are several possible alternative arrangements effecting this suction step.

In a first possible arrangement the suction step of creating a partial vacuum is performed by creating the partial vacuum in the closed vessel while the particulate solids are located therein and the step of directing microwave radiation comprises directing microwave energy into the particulate solids below the surface level of the particulate solids in the closed vessel whereby a significant and preferably major proportion of the available energy is absorbed in the particulate solids before that energy reaches the gas space above the particulate solids level. This reduces the chance of plasma formation in the gas space above the particulate solids which is more likely to occur in a lower vapour pressure space.

In a second possible arrangement having the suction step, the directing of microwave radiation into the vessel is discontinued after a period of heating time, and substantially simultaneously with or after the discontinuation of the step of directing microwave radiation the step of creating the partial vacuum is performed so as to create the partial vacuum in the closed vessel. This also reduces the likelihood of plasma formation and arcing occurring in the gas space when the suction step is performed to lower the vapour pressure.

In a third possible arrangement having the suction step, after the step of directing microwave radiation to heat the particulate solids is ended, the heated particulate solids are then transferred from the closed vessel to an extraction stage, thereby enabling further contaminated particulate solids to be located in the closed vessel for being heated therein, and the suction step of creating the partial vacuum is performed in the extraction stage to promote vaporization of PFAS from the particulate solids. This separates the vaporization under the partial vacuum from the microwave heating so the plasma formation/arcing is not a risk in the suction step.

The method according to the second aspect of the invention may further include a plasma inhibition step performed to inhibit formation of plasma in a gas space above the level of particulate solids during the step of directing microwave radiation into the particulate solids to cause heating thereof. For example, the plasma inhibition step may comprise performing the microwave heating of the particulate solids in two stages consisting of (i) a higher power heating stage during which higher power microwave energy is applied to the particulate solids while simultaneously a pressure within the vessel greater than atmospheric pressure (101 kPa) is maintained, and (ii) a lower power microwave heating stage in which a lower power level of microwave radiation is applied to the particulate solids and simultaneously a partial vacuum is created in the vessel in which the lower power microwave radiation is being applied and during which PFAS are being vaporized for removal from the particulate solids.

In this example, the higher power microwave heating stage and lower power microwave heating stage may be alternated so as to improve the effectiveness of PFAS extraction by higher power heating and higher vacuum extraction.

Alternatively to the two stage heating, or in conjunction therewith, the plasma inhibition step may include substantially increasing the amount of inert gas, particularly helium or neon or argon, in the gas atmosphere mixed with and surrounding the particulate solids undergoing heating by microwave radiation so as to thereby inhibit the creation of a plasma in the gas space above the level of particulate solids in the vessel where microwave irradiation is occurring. The high ionization temperature of helium particularly inhibits the creation of a plasma in the gas.

The method according to the second aspect of the invention may further include a particulate sizing step performed prior to locating the body of particulate solids in the closed vessel to optimize the sizes of the particulate solids to achieve desirable dielectric properties of the particulate solids for their microwave heating. Sizing may be performed by any suitable process such as those used in mineral processing technologies, including crushing and sizing. Such sizing can be most desirable for remediation of PFAS contaminated concrete, paving, asphalt, bitumen, tarmac etc. so as to increase the surface area of the particulate solids and promote extraction of PFAS therefrom.

Preferably the microwave radiation directed to the body of particulate solids is generated by a microwave generator and a waveguide transfers the microwave radiation to the closed vessel through a microwave transparent wall of, or window in, the closed vessel, the waveguide preferably incorporating a tuner operative to match impedance of the microwave generator and associated waveguide to the impedance of the load consisting of the particulate solids in the closed vessel so as to thereby improve microwave energy transfer efficiency to the particulate solids. The tuner may comprise an auto-tuner (such as a three stub tuner) operated under a control system responsive to a dielectric coupler for sensing the reflected power in the waveguide so that the reflected power is minimized.

The particularly preferred method for remediating particulate solids, particularly soil, contaminated by per- and poly-fluoroalkyl substances (PFAS) comprise the substantially complete removal of PFAS using electromagnetic microwave radiation to effect induction heating to vaporise the contaminants followed by destruction of the PFAS using microwave induced plasma technology.

### Introduction to the Drawings

Possible and preferred features of the present invention will now be described with particular reference to the accompanying drawings. However it is to be understood that the features illustrated in and described with reference to the drawings are not to be construed as limiting on the scope of the invention. In the drawings:
Fig. 1 is a schematic diagram showing apparatus for processing PFAS to at least partially convert them into safer substances.
Fig. 2 is a schematic diagram showing apparatus for continuous processing of contaminated particulate solids, particularly soil.
Fig. 3 is a schematic diagram of an apparatus for batch treatment of contaminated particulate solids, particularly soil.
Fig. 4 is a diagram indicating the process steps for remediation of particulate solids.

### Description of Embodiments

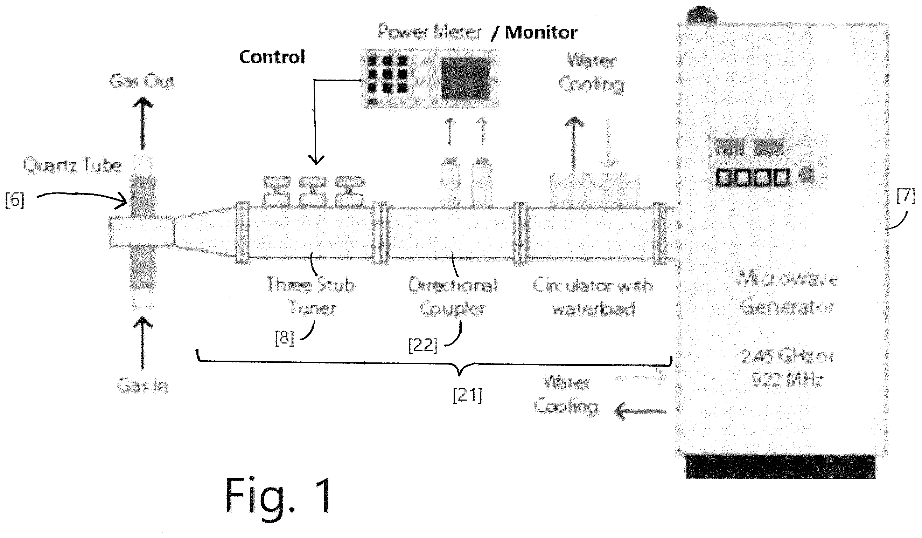

Referring to Fig. 1, which shows apparatus for processing PFAS to at least partially convert them into safer substances, gaseous or vapour phase PFAS are introduced in the feed labelled "Gas In" into a treatment zone [6] such as the illustrated (microwave transparent) quartz tube. The treatment zone [6] is irradiated with microwave radiation of predetermined frequency or frequencies and power level or levels so as to create a plasma in the treatment zone [6] so that the plasma in the treatment zone at least partially dissociates the PFAS and produces safer substances including less toxic atoms, molecules and/or radicals which are removed through the outlet labelled "Gas Out". The PFAS are continuously introduced into the treatment zone [6] and dissociation products are continuously withdrawn with the flow rate and plasma temperature being sufficient to effect substantially complete conversion of the PFAS into safer substances.

The microwave radiation is generated by a microwave generator [7] and a waveguide [21] transfers the microwave radiation to the treatment zone [6] through a microwave transparent wall of, or window in, the treatment zone which is comprised by the quartz tube walls in Fig. 1. The waveguide [21] incorporates a tuner [8] operative to match impedance of the microwave generator [7] and associated waveguide to the impedance of the load consisting of the PFAS in the treatment zone [6] so as to thereby improve microwave energy transfer efficiency to the treatment zone and improve the plasma creation. The waveguide [21] includes a directional coupler [22] to detect and monitor the reflected power which is used to control the tuner [8] in known manner.

It is known that microwave electric fields of sufficient strength can induce an ionised gas, also known as a plasma. Under atmospheric conditions air will break down forming a plasma when the electric field stress is in the vicinity of 30kV/cm. The specific electric field strength to initiate a plasma will depend on many parameters such is temperature, gas ionisation energy and pressure.

Microwave plasmas are typically initiated in single mode cavities where their resonant nature gives rise to very high field strengths, however plasma can form in non-resonant multimode applicators provided there is sufficient electric field strength. The field strength is proportional to the square root of the applied power level.

The dimensions and configuration of suitable microwave applicators for plasma processing is very much dependent upon the frequency of operation which can be anywhere between 800 MHz to 30 GHz, however the most likely frequencies are 896 MHz, 915 MHz, 922 MHz and 2.45 GHz as these are commercially used in industry.

The power levels required will be dependent upon frequency, gas throughput and pressure and could be as low as 1 kW and as high as 300 kW.

The unique ability of a plasma to cause molecule disassociation into fundamental components is largely due to a combination of the average bulk ion temperature and extremely high individual ion temperatures. Free electrons in the plasma can have very high energy and hence very high individual ion temperatures. The bulk temperatures required are expected to be in the order of 800-1200°C and the individual ion temperatures may be in the order of 1000 to 10,000⁰K.

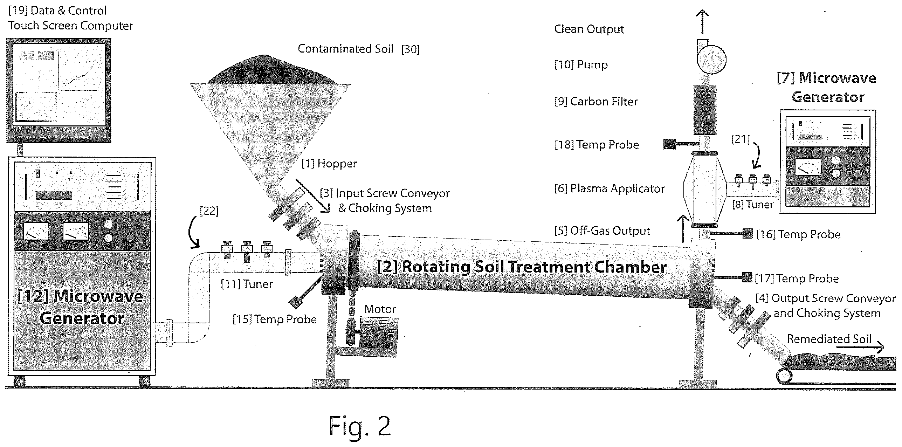

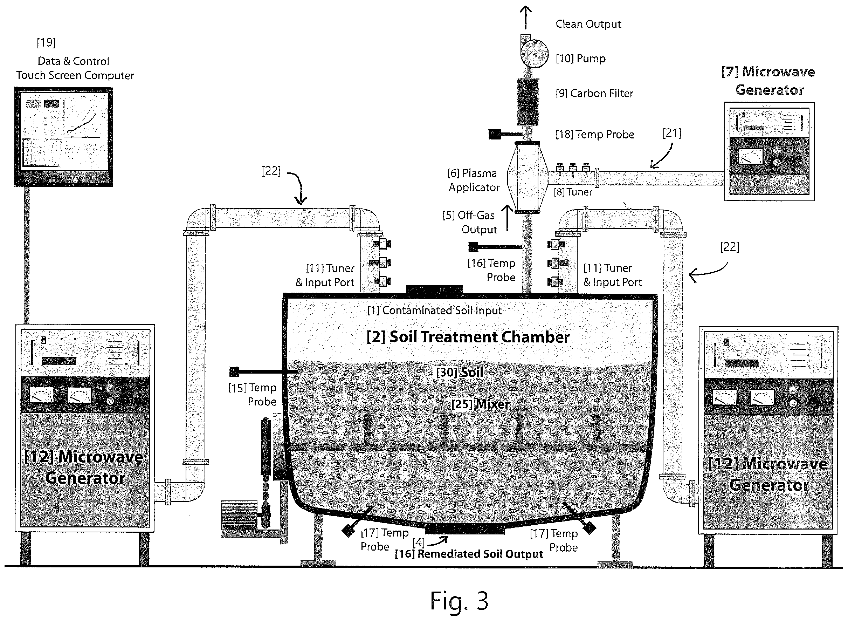

In each of Figs. 2 and 3 there is an apparatus for separating per- and poly-fluoroalkyl substances (PFAS) from particulate solids, particularly soil, followed by the destruction of the PFAS. The apparatus will be described with reference to treating contaminated soil. The apparatus comprises a material feeder to deliver soil to the treatment chamber in a closed vessel, which is a rotating treatment chamber (Fig. 2) or a mixing chamber (Fig. 3). The soil contaminated with PFAS and located in the vessel are mixed either intermittently or continuously while being irradiated by microwave radiation so as to promote heating of the soil by dielectric heating and vaporisation of PFAS. The closed vessel has a microwave transparent window for keeping the microwave emitter clean. A microwave generator exposes the soil to microwave energy via an impedance matching tuner. Microwave energy exposed to soil in the treatment chamber substantially completely removes and separates the liquids and PFAS from the soil which is drawn out and processed through a treatment stage utilising a microwave induced plasma to destroy the PFAS, followed by a filter collecting particulates. It is not necessary that the boiling points of the PFAS in the soil being treated are reached in the treatment chamber because the PFAS will vaporise progressively without necessarily reaching boiling point. The treatment stage may be substantially as described above and illustrated with reference to Fig. 1.

Referring to Fig. 2, PFAS contaminated soil [30] is drawn from the storage hopper [1] and progressively fed into the vessel having the treatment chamber [2] via a screw conveyor [3]. This can be by continuous feeding of soil or by intermittent feeding of charges of soil. In the chamber [2] of the vessel the soil is dielectrically heated by microwave energy to temperatures promoting vaporisation of PFAS (not necessarily gasification) and the soil that has yielded up PFAS by vaporisation is progressively is removed through outlet [4]. The PFAS are removed through outlet [5] as a vapour. The vapour is then passed through a microwave plasma afterburner [6], e.g. operating at suitable temperatures, e.g. above 800⁰C, and PFAS are destroyed, by dissociation of the PFAS molecules.

The input [3] and output [4] screw conveyors are lined with microwave chokes [3, 4] to prevent electromagnetic radiation from escaping the treatment chamber.

The treatment chamber [2] rotates to provide mixing of the soil which helps produce a homogeneous heating profile and release vapours (including PFAS). The treatment chamber [2] is angled to allow a gravity assisted flow of product from input to output assisted by the rotation of the chamber and the input [3] and output [4] screw conveyors. The tubular chamber [2] may also be either continuously or intermittently vibrated as well as rotated so that the soil progressively travels by gravity down the inclined tube to the exit [4] therefrom.

Vapours are drawn out of the chamber through the gas output [5] and passed through a microwave plasma treatment stage [6] to destroy the PFAS via thermal oxidation and/or dissociation.

The plasma is produced using a microwave generator [7] operating within the frequency spectrum of 300 MHz to 5 GHz and requires a tuning system [8] in the waveguide [21] for impedance matching.

The neutralised gases and particulates from the gas stream are then filtered [9] or adsorbed or otherwise processed to render them safe.

A pump [10] is used to extract the gasses from the treatment chamber and lower the pressure of the system.

An impedance matching tuner [11] is utilised in the waveguide [22] before the microwave input port, on the generator side, to maximise the amount of electromagnetic energy being absorbed by the soil. Tuning and impedance matching by tuner [11] can help to avoid a need or desirability of using a catalyst (high dielectric loss) in the particulate solids although such use of a catalyst can be possible if desired.

Electromagnetic energy from a microwave generator [12] operating within the frequency spectrum of 300 MHz to 5 GHz, is delivered to the treatment chamber [2] via waveguide [22].

Microwave transparent windows between the tuner [11] and treatment chamber [2] prevents soil and gases from entering the microwave waveguide [22].

Temperature probes [15, 16, 17, 18] are used at both ends of the treatment chamber [2] as well as at each input and output in order monitor the soil and vapour temperatures and enable process control.

The treatment chamber [2] is insulated with *TBD* material to maintain required internal temperatures.

The remediated soil is removed via the output screw conveyor and choke [4].

Energy levels, heating rates, input and output speed, rotation speed, temperatures and other monitored and controllable inputs and outputs are controlled, monitored and recorded via Touch Screen Computer Control System [19].

In Fig. 3, a batch of soil [30] contaminated with PFAS is located in chamber [2] of a the closed vessel, and during irradiation by the microwave radiation, the batch is mixed either intermittently or continuously, e.g. by mixer [25] shown as a helical blade, so as to expose the batch of soil solids substantially throughout its volume to the microwave irradiation for a vaporisation period during which no further soil is added to the vessel. This mixing can ensure uniform processing and thorough PFAS extraction. Vapour containing the PFAS yielded up by the batch of soil is removed from the closed vessel for downstream treatment prior to opening of the vessel and discharge of the treated particulate solids therein.

In the particular apparatus in Fig. 3, the chamber [2] is first opened and a charge of contaminated soil [30] is fed into the chamber. The chamber is closed and the soil therein is irradiated by microwaves from the two generators [12]. The soil in the chamber is continuously or intermittently mixed by any suitable mixer or agitator [25] operating within the chamber so that the soil being treated is thoroughly irradiated to promote dielectric heating leading to vaporisation and removal of the PFAS. The batch processing apparatus of Fig. 3 is otherwise operated substantially the same as the apparatus of Fig. 2.

The pump [10] which creates suction to draw PFAS out of the treatment chamber [2] and through the treatment stage constituted by the plasma applicator [6] can reduce the vapour pressure in the treatment chamber and hence assist vaporisation of PFAS, although the function of the pump is also to draw the PFAS vapour from the chamber through the treatment stage. Thus the vapour containing PFAS is continuously drawn from the chamber [2] and transferred into the treatment stage [6] during the treatment of the particulate solids in the vessel by creating a negative pressure downstream of the treatment stage which thereby draws vapours from the vessel into and through the treatment stage. However it is also possible that vapour containing PFAS yielded by the soil [30] is drawn from the vessel after the irradiation of the soil in the vessel.

Because removal of water from the soil [30] being treated which occurs under the effects of the microwave irradiation generally increases the permeability of the soil to microwave energy, the process and apparatus may have a two-stage (or more than two-stage) operation. In particular, in a first-stage, the microwave irradiation is primarily conducted using parameters for vaporising water in the soil. This increases the microwave permeability of the progressively drying soil so that, in a second stage, the power of the microwave radiation generated and transmitted into the treatment chamber [2] is increased to more effectively vaporise PFAS in the at least partially dried soil.

In a further possible embodiment of the invention, the chamber [2] in which the soil is irradiated may include (or may consist of) a microwave transparent enclosure, e.g. composed of quartz or ceramic or other microwave transparent material, in which the soil resides during the irradiation. The enclosure may comprise for example a quartz or ceramic tube into which soil to be treated is fed, the tube being inclined and either continuously or intermittently vibrated so that the soil progressively travels by gravity down the inclined tube to an exit therefrom. The vibration will promote penetration of the microwave radiation (and heating effects) and / or direct exposure of the soil surfaces and interstices as the soil particles are agitated and loosened and separated and as they mix and migrate. A suitable apparatus may be a vibrator coupled to the tube and used to promote granular flow e.g. of the type in the mining industry or other industries where flow of particulates in a tube or pipe or the like is required. The vibration frequency and amplitude, and the angle of inclination of the tube, will be parameters that affect the soil movement speed through the irradiation zone, and these parameters may be selectively variable and may be empirically determined to optimise the process.

In both of the particular embodiments of Figs 2 and 3, the soil can be subject to a two-stage heating process comprising: a first preheating stage in which the soil is heated to vaporize water and thereby dry the soil to a pre-determined moisture content, and a second higher energy heating stage in which microwave irradiation of the soil having the reduced moisture content occurs to promote vaporization of PFAS. The first preheating stage in which the soil is heated to dry the soil to a pre-determined moisture content can be performed at least partially before the soil is fed to the closed vessel, i.e. upstream of the soil inlet to the chamber [2]. The first preheating stage may comprise or include conventional heating by conduction or thermal (IR) radiation, (including before introduction into the chamber [2] of the closed vessel), and induction heating by low power microwave may also or alternatively be used. The microwave generator [12] used for the PFAS vaporization second heating stage can be operated at a lower power level for the first preheating stage.

In both of the particular embodiments of Figs 2 and 3 and in variations thereof, the apparatus may include means for creating a partial vacuum where soil [30] is heated by the microwave radiation directed into the chamber [2] of the closed vessel so as to promote vaporization of PFAS from the soil. The operation of the pump [10] in the illustrated embodiments is one possible arrangement for effecting this suction.

In a first possible arrangement the means for creating a partial vacuum is performed by creating the partial vacuum in the closed vessel while the soil [30] is located therein and, unlike Fig 3, the microwave radiation is directed into the soil [30] below the surface level of the soil in the closed vessel whereby a significant and preferably major proportion of the available energy is absorbed in the soil before that energy reaches the gas space above the soil surface. This reduces the chance of plasma formation in the gas space above the soil which is more likely to occur in a lower vapour pressure space.

In a second possible arrangement having the means for creating a partial vacuum, the directing of microwave radiation into the soil is discontinued after a period of heating time, and substantially simultaneously with or after the discontinuation of the step of directing microwave radiation the partial vacuum is created in the closed vessel. This also reduces the likelihood of plasma formation and arcing occurring in the gas space when the suction step is performed to lower the vapour pressure.

In a third possible arrangement having the means for creating a partial vacuum, and applicable to the batch system of Fig. 3, after the step of directing microwave radiation to heat the particulate solids is ended, the heated soil is then transferred from the chamber [2] in the closed vessel to a separate extraction stage, thereby enabling further contaminated soil [30] to be located in the chamber [2] of the closed vessel for being heated therein, and the means for creating the partial vacuum is operated to create the partial vacuum e.g. in a closed chamber of the separate extraction stage to promote vaporization of PFAS from the heated soil. This separates the vaporization under the partial vacuum from the microwave heating so the plasma formation/arcing is not a risk in the suction operation.

Also in both of the particular embodiments of Figs 2 and 3 and in variations thereof, the apparatus may includes means for effecting a plasma inhibition to inhibit formation of plasma in a gas space above the level of soil during the step of directing microwave radiation into the soil to cause heating thereof. For example, the plasma inhibition may be effected by performing the microwave heating of the soil in two stages consisting of (i) a higher power heating stage during which higher power microwave energy is applied to the soil [30] while simultaneously a pressure within the chamber [2] of the vessel greater than atmospheric pressure (101 kPa) is maintained, and (ii) a lower power microwave heating stage in which a lower power level of microwave radiation is applied to the soil and simultaneously a partial vacuum is created in the vessel in which the lower power microwave radiation is being applied and during which PFAS are being vaporized for removal from the soil. In this embodiment, the higher power microwave heating stage and lower power microwave heating stage may be alternated so as to improve the effectiveness of PFAS extraction by higher power heating and higher vacuum extraction.

Alternatively, to the two stage heating, or in conjunction therewith, the plasma inhibition may include substantially increasing the amount of inert gas, particularly helium or neon or argon, in the gas atmosphere mixed with and surrounding the soil [30] undergoing heating by microwave radiation so as to thereby inhibit the creation of a plasma in the gas space above the level of soil [30] in the chamber [2] of the vessel where microwave irradiation is occurring. The high ionization temperature of helium particularly inhibits the creation of a plasma in the gas.

In both of the particular embodiments of Figs 2 and 3 and in variations thereof, the apparatus may further include a means for sizing the particulate solids generally, or soil in the particular embodiments, prior to locating the body of particulate solids in the chamber [2] of the closed vessel to optimize the sizes of the particulate solids to achieve desirable dielectric properties of the particulate solids for their microwave heating. Sizing of the particulate can enable matching or optimization of microwave penetration depths in different soils, concrete, asphalt, etc. Sizing may be performed by any suitable apparatus such as those used in mineral processing technologies, including crushing and sizing. Such sizing can be most desirable for remediation of PFAS contaminated concrete, paving, asphalt, bitumen, tarmac etc. so as to increase the surface area of the particulate solids and promote extraction of PFAS therefrom.

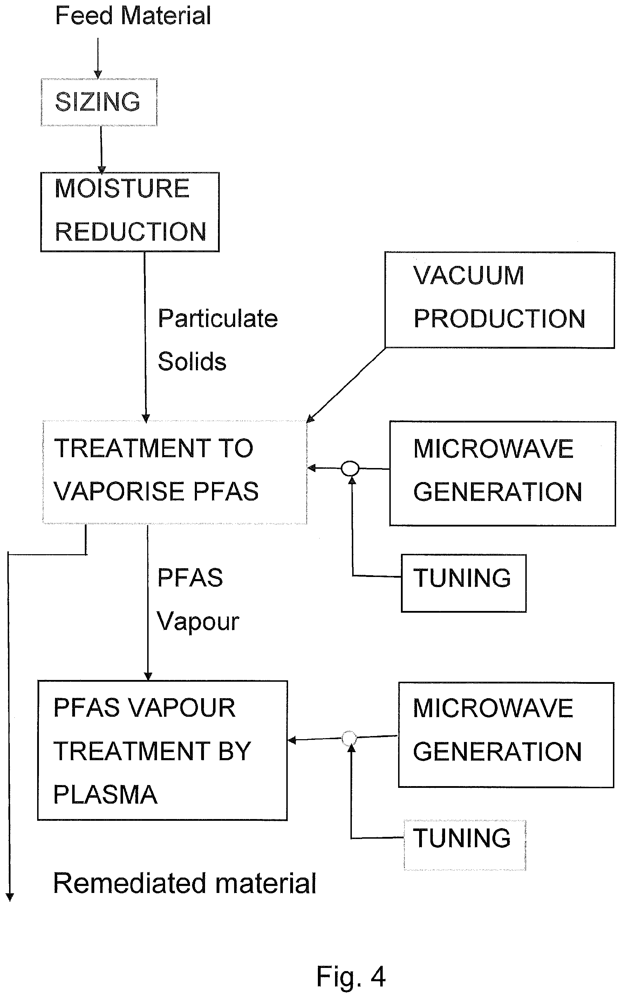

The diagram of Fig. 4 illustrates the processes of the invention used for remediation of contaminated solid particulate materials. The treatment to vaporise PFAS can be performed by the apparatus of Fig. 2 (continuous processing) or of Fig. 3 (batch processing). The vacuum production may comprise application of suction as exemplified in Fig. 2 to draw vaporised PFAS from the heating and vaporising chamber through the treatment zone. Alternatively, the vacuum production may comprise means for effecting any of the alternative vacuum creating embodiments described herein, including:
- applying a partial vacuum while microwave energy is applied into the particulate solids in the closed vessel below the surface, or
- applying the vacuum upon or after discontinuation of the microwave heating of particulate solids in the closed vessel, or
- transferring the heated particulate solids from the closed vessel in which the microwave heating has occurred to a separate closed extraction chamber to which the vacuum is applied.

In Fig. 4 the PFAS vapour treatment by plasma may comprise the treatment as described in relation to Fig. 1.

It will be seen that the particular preferred embodiments of possible apparatus described and illustrated herein can be used to effectively remediate soil contaminated with PFAS. The processed soil may be of better quality for re-introduction to the environment since lower temperatures are used in the PFAS extraction compared to prior soil heating systems. The apparatus can be sufficiently small scale to be transported to a site where the contaminated soil to be treated is located and the apparatus can be set up and operated at the site by systematically collecting soil throughout the site and processing it according to the method and apparatus of the invention for immediate return.

It is to be understood that various alterations, modifications and/or additions may be made to the features of the possible and preferred embodiment(s) of the invention as herein described without departing from the scope of the invention, which is defined by the appended claims.

## Claims

1. A method for remediating particulate solids contaminated with PFAS, the method including the steps of:
locating a body of particulate solids contaminated with PFAS in a closed vessel,
generating microwave radiation of pre-determined frequency or frequencies and power level or levels,
directing microwave radiation generated to the body of particulate solids in the vessel so as to heat the particulate solids and promote vaporisation of PFAS,
transferring vapour from the vessel to a treatment stage, and
treating in the treatment stage the vapour transferred from the vessel so as to at least partially convert the PFAS into safer substances.

2. A method according to claim 1**,** the method including the further step of creating a partial vacuum where particulate solids heated by the microwave radiation directed into the closed vessel are located so as to promote vaporization of PFAS from the particulate solids.

3. A method according to claim 2 wherein the step of creating a partial vacuum is performed by creating the partial vacuum in the closed vessel while the particulate solids are located therein and wherein the step of directing microwave radiation comprises directing microwave energy into the particulate solids below the surface level of the particulate solids in the closed vessel whereby a significant proportion of the available energy is absorbed in the particulate solids before that energy reaches the gas space above the particulate solids level thereby reducing the chance of plasma formation in the gas space above the particulate solids.

4. A method according to claim 2 wherein the step of directing microwave radiation is discontinued after a period of heating time, and wherein substantially simultaneously with or after the discontinuation of the step of directing microwave radiation the step of creating the partial vacuum is performed so as to create the partial vacuum in the closed vessel.

5. A method according to claim 2 wherein after the step of directing microwave radiation to heat the particulate solids is ended, the heated particulate solids are transferred from the closed vessel to an extraction stage, thereby enabling further contaminated particulate solids to be located in the closed vessel for being heated therein, and wherein the step of creating the partial vacuum is performed to promote vaporization of PFAS from the particulate solids in the extraction stage.

6. A method according to any one of claims 2 to 5 and further including a plasma inhibition step performed to inhibit formation of plasma in a gas space above the level of particulate solids during the step of directing microwave radiation into the particulate solids to cause heating thereof.

7. A method according to claim 6 wherein the plasma inhibition step comprises performing the microwave heating of the particulate solids in two stages consisting of (i) a higher power heating stage during which higher power microwave energy is applied to the particulate solids while simultaneously a pressure within the vessel greater than atmospheric pressure (101 kPa) is maintained, and (ii) a lower power microwave heating stage in which a lower power level of microwave radiation is applied to the particulate solids and simultaneously a partial vacuum is created in the vessel in which the lower power microwave radiation is being applied and during which PFAS are being vaporized for removal from the particulate solids.

8. A method according to claim 7 wherein the higher power microwave heating stage and lower power microwave heating stage are alternated so as to improve the effectiveness of PFAS extraction by higher power heating and higher vacuum extraction.

9. A method according to any one of claims 6 to 8 wherein the plasma inhibition step includes substantially increasing the amount of inert gas, particularly helium or neon or argon, in the gas atmosphere mixed with and surrounding the particulate solids undergoing heating by microwave radiation so as to thereby inhibit the creation of a plasma in the gas space above the level of particulate solids in the vessel where microwave irradiation is occurring.

10. A method according to any one of claims 1 to 9 wherein the step of treating the vapour in the treatment stage comprises exposing the vapour to a plasma within a treatment zone whereby PFAS in the vapour entering and passing through the treatment zone are subject to at least partial dissociation of the PFAS molecules.

11. A method according to claim 10 wherein the plasma in the treatment zone is created and/or is maintained by directing to the treatment zone microwave radiation from a secondary microwave generator operatively associated with the treatment zone.

12. A method according to claim 10 or 11 wherein particulate solids contaminated with PFAS are progressively fed into the vessel, whether by continuous feeding of particulate solids or by intermittent feeding of charges of particulate solids, and heated particulate solids that have yielded up PFAS by vaporisation are progressively removed from the vessel so that the particulate solids progressively move from a soil feed location of the vessel to a soil removal location of the vessel while being exposed to microwave irradiation, and wherein the chamber in which the particulate solids are irradiated has a microwave transparent wall or window through which the particulate solids are exposed to the irradiation, the enclosure comprising a tube into which particulate solids to be treated are fed, the tube being inclined and being either continuously or intermittently vibrated and/or rotated so that the particulate solids progressively travel by gravity down the inclined tube to an exit therefrom.

13. A method according to claim 10 or 11 wherein a batch of particulate solids contaminated with PFAS is located in the closed vessel, and during irradiation by the microwave radiation, the batch is mixed either intermittently or continuously so as to expose the batch of particulate solids substantially throughout its volume to the microwave irradiation for a vaporisation period during which no further particulate solids are added to the vessel, and wherein vapour containing the PFAS yielded up by the batch is removed from the closed vessel for downstream treatment prior to opening of the vessel and discharge of the treated particulate solids therein.

14. A method according to any one of claims 10 to 13 wherein the particulate solids are subject to a two-stage heating process comprising:
a first preheating stage in which the particulate solids are heated to vaporize water in the particulate solids and thereby dry the particulate solids to a pre-determined moisture content, and
a second higher energy heating stage in which microwave irradiation of the particulate solids having the reduced moisture content occurs to promote vaporization of PFAS.

15. A method according to any one of claims 10 to 12 wherein vapour containing PFAS yielded by the particulate solids is drawn from the vessel during the irradiation of the particulate solids in the vessel, and wherein the vapour containing PFAS is continuously drawn from the vessel and transferred into the treatment stage during the treatment of the particulate solids in the vessel by creating a negative pressure downstream of the treatment stage which thereby draws vapours from the vessel into and through the treatment stage.

## Patentansprüche

1. Ein Verfahren zur Sanierung von partikulären Feststoffen, die mit PFAS verschmutzt sind, das Verfahren beinhaltet dabei folgende Schritte:
Lokalisierung eines Körpers aus partikulären Feststoffen, die mit PFAS verschmutzt sind, in einem geschlossenen Gefäß,
Erzeugung von Mikrowellenstrahlung mit vorher festgelegter Frequenz oder Frequenzen und Stärke oder Stärken,
Richten der erzeugten Mikrowellenstrahlung auf den Körper der partikulären Feststoffe im Gefäß, um die partikulären Feststoffe zu erhitzen und die Verdampfung von PFAS zu fördern,
Weiterleitung von Dampf aus dem Gefäß zu einer Aufbereitungsstufe, und
Aufbereitung in der Aufbereitungsstufe des vom Gefäß weitergeleiteten Dampfs, um die PFAS zumindest teilweise in sicherere Stoffe umzuwandeln.

2. Ein Verfahren nach dem Patentanspruch 1, das Verfahren dabei den weiteren Schritt der Erzeugung eines Teilvakuums beinhaltend, wobei partikuläre Feststoffe, die durch die in das geschlossene Gefäß gerichtete Mikrowellenstrahlung erhitzt wurden, lokalisiert werden, um die Verdampfung von PFAS aus den partikulären Feststoffen zu fördern.

3. Ein Verfahren nach dem Patentanspruch 2, wobei der Schritt der Erzeugung eines Teilvakuums durchgeführt wird, indem das Teilvakuum in dem geschlossenen Gefäß erzeugt wird, während sich die partikulären Feststoffe darin befinden, und wobei der Schritt des Richtens von Mikrowellenstrahlung beinhaltet, Mikrowellenenergie in die partikulären Feststoffe unterhalb des Oberflächenniveaus der partikulären Feststoffe in dem geschlossenen Gefäß zu richten, wodurch ein signifikanter Anteil der verfügbaren Energie in den partikulären Feststoffen absorbiert wird, bevor diese Energie den Gasraum oberhalb des Niveaus der partikulären Feststoffe erreicht, dadurch die Möglichkeit von Plasmabildung im Gasraum über den partikulären Feststoffen reduzierend.

4. Ein Verfahren nach dem Patentanspruch 2, wobei der Schritt des Richtens von Mikrowellenstrahlung nach einem Erhitzungszeitraum unterbrochen wird, und wobei im Wesentlichen gleichzeitig mit oder nach der Unterbrechung des Schritts des Richtens von Mikrowellenstrahlung der Schritt der Erzeugung des Teilvakuums durchgeführt wird, um das Teilvakuum in dem geschlossenen Gefäß zu erzeugen.

5. Ein Verfahren nach dem Patentanspruch 2, wobei, nachdem der Schritt des Richtens von Mikrowellenstrahlung, um die partikulären Feststoffe zu erhitzen, beendet wird, die erhitzten partikulären Feststoffe von dem geschlossenen Gefäß zu einer Extraktionsstufe weitergeleitet werden, dadurch ermöglichend, dass weitere verschmutzte partikuläre Feststoffe in dem geschlossenen Gefäß lokalisiert werden, um darin erhitzt zu werden, und wobei der Schritt der Erzeugung des Teilvakuums durchgeführt wird, um die Verdampfung von PFAS aus den partikulären Feststoffen in der Extraktionsstufe zu fördern.

6. Ein Verfahren nach jedem der Patentansprüche 2 bis 5 und weiter einen Plasmahemmungsschritt beinhaltend, der durchgeführt wird, um die Bildung von Plasma in einem Gasraum oberhalb des Niveaus der partikulären Feststoffe während des Schritts des Richtens von Mikrowellenstrahlung in die partikulären Feststoffe, um deren Erhitzung zu verursachen, zu hemmen.

7. Ein Verfahren nach dem Patentanspruch 6, wobei der Plasmahemmungsschritt die Mikrowellenerhitzung der partikulären Feststoffe in zwei Stufen beinhaltet, die bestehen aus (i) einer Erhitzungsstufe mit höherer Stärke, bei der eine höhere Mikrowellenenergiestärke auf die partikulären Feststoffe angewandt wird, während gleichzeitig innerhalb des Gefäßes ein Druck, größer als der Atmosphärendruck (101 kPa), beibehalten wird, und (ii) einer Erhitzungsstufe mit niedrigerer Stärke, bei der eine niedrigere Stärke von Mikrowellenstrahlung auf die partikulären Feststoffe angewandt wird und gleichzeitig ein Teilvakuum in dem Gefäß erzeugt wird, bei dem die Mikrowellenstrahlung mit niedrigerer Stärke angewandt wird und während der PFAS zur Entfernung aus den partikulären Feststoffen verdampft werden.

8. Ein Verfahren nach dem Patentanspruch 7, wobei die Erhitzungsstufe mit höherer Mikrowellenstärke und die Erhitzungsstufe mit niedrigerer Mikrowellenstärke abgewechselt werden, um die Wirksamkeit der PFAS-Extraktion durch Erhitzung mit höherer Stärke und Extraktion mit höherem Vakuum zu verbessern.

9. Ein Verfahren nach jedem der Patentansprüche 6 bis 8, wobei der Plasmahemmungsschritt im Wesentlichen die Erhöhung der Menge an Inertgas, im Besonderen Helium oder Neon oder Argon, in der Gasatmosphäre, mit den partikulären Feststoffen, die der Erhitzung durch Mikrowellenstrahlung unterzogen werden, gemischt und diese umgebend, beinhaltet, um dadurch die Erzeugung eines Plasmas in dem Gasraum oberhalb des Niveaus der partikulären Feststoffe in dem Gefäß, in dem die Mikrowellenbestrahlung gerade stattfindet, zu hemmen.

10. Ein Verfahren nach jedem der Patentansprüche 1 bis 9, wobei der Schritt der Aufbereitung des Dampfs in der Aufbereitungsstufe beinhaltet, den Dampf in einem Aufbereitungsbereich einem Plasma auszusetzen, wobei PFAS in dem Dampf, der in den Aufbereitungsbereich gelangt und ihn passiert, zumindest teilweise einer Dissoziation der PFAS-Moleküle unterliegen.

11. Ein Verfahren nach dem Patentanspruch 10, wobei das Plasma im Aufbereitungsbereich erzeugt und/oder erhalten wird, indem Mikrowellenstrahlung von einem zweiten Mikrowellengenerator, der operativ mit dem Aufbereitungsbereich verknüpft ist, in den Aufbereitungsbereich gerichtet wird.

12. Ein Verfahren nach dem Patentanspruch 10 oder 11, wobei mit PFAS verschmutzte partikuläre Feststoffe nach und nach in das Gefäß zugeführt werden, entweder durch kontinuierliche Zuführung von partikulären Feststoffen oder durch intermittierende Zuführung von partikulären Feststoffen, und erhitzte partikuläre Feststoffe, die PFAS durch Verdampfung freigegeben haben, nach und nach aus dem Gefäß entfernt werden, sodass die partikulären Feststoffe fortschreitend von einem Bodenzuführungsort des Gefäßes an einen Bodenentfernungsort des Gefäßes bewegt werden, während sie Mikrowellenstrahlung ausgesetzt werden, und wobei die Kammer, in der die partikulären Feststoffe bestrahlt werden, eine mikrowellendurchlässige Wand oder ein mikrowellendurchlässiges Fenster hat, durch die/das die partikulären Feststoffe der Bestrahlung ausgesetzt werden, das Gehäuse beinhaltet dabei einen Schlauch, in den aufzubereitende partikuläre Feststoffe zugeführt werden, der Schlauch ist dabei in einer Schräglage und wird dabei entweder kontinuierlich oder intermittierend gerüttelt und/oder gedreht, sodass die partikulären Feststoffe fortschreitend aufgrund von Schwerkraft durch den schräg liegenden Schlauch zu einem Auslass daraus hinuntergleiten.

13. Ein Verfahren nach dem Patentanspruch 10 oder 11, wobei sich eine Charge mit PFAS verschmutzter partikulärer Feststoffe in dem geschlossenen Gefäß befindet und wobei während der Bestrahlung mit der Mikrowellenstrahlung die Charge während eines Verdampfungszeitraums, in dem keine weiteren partikulären Feststoffe in das Gefäß hinzugefügt werden, entweder intermittierend oder kontinuierlich vermischt wird, um die Charge von partikulären Feststoffen im Wesentlichen durch ihr gesamtes Volumen hindurch der Mikrowellenstrahlung auszusetzen, und wobei Dampf, der die von der Charge freigegebenen PFAS enthält, aus dem geschlossenen Gefäß für eine nachfolgende Aufbereitung entfernt wird, bevor das Gefäß geöffnet wird und die aufbereiteten partikulären Feststoffe darin ausgegeben werden.

14. Ein Verfahren nach jedem der Patentansprüche 10 bis 13, wobei die partikulären Feststoffe einem zweistufigen Erhitzungsverfahren unterzogen werden, das Folgendes beinhaltet:
eine erste Vorerhitzungsstufe, bei der die partikulären Feststoffe erhitzt werden, um Wasser in den partikulären Feststoffen zu verdampfen und dadurch die partikulären Feststoffe bis auf einen vorher festgelegten Feuchtigkeitsgehalt auszutrocknen, und
eine zweite Erhitzungsstufe mit höherer Energie, bei der eine Mikrowellenbestrahlung der partikulären Feststoffe, die den verringerten Feuchtigkeitsgehalt haben, erfolgt, um die Verdampfung von PFAS zu fördern.

15. Ein Verfahren nach jedem der Patentansprüche 10 bis 12, wobei Dampf, der von den partikulären Feststoffen freigegebene PFAS enthält, während der Bestrahlung der partikulären Feststoffe in dem Gefäß aus dem Gefäß abgesaugt wird, und wobei der PFAS enthaltende Dampf kontinuierlich aus dem Gefäß abgesaugt und während der Aufbereitung der partikulären Feststoffe in dem Gefäß in die Aufbereitungsstufe weitergeleitet wird, indem nach der Aufbereitungsstufe ein Negativdruck erzeugt wird, der dadurch Dämpfe aus dem Gefäß in und durch die Aufbereitungsstufe hindurch saugt.

## Revendications

1. Un procédé d'assainissement de solides particulaires contaminés par des PFAS, le procédé comprenant les étapes consistant à :
localiser un corps de solides particulaires contaminé par des PFAS dans une cuve fermée,
générer un rayonnement micro-ondes de fréquence ou fréquences et de niveau ou niveaux de puissance prédéterminés,
diriger le rayonnement micro-ondes généré vers le corps de solides particulaires dans la cuve de manière à chauffer les solides particulaires et à favoriser la vaporisation des PFAS,
transférer la vapeur de la cuve à un étage de traitement, et
traiter, dans l'étage de traitement, la vapeur transférée de la cuve de manière à convertir au moins partiellement les PFAS en substances plus sûres.

2. Un procédé selon la revendication 1, le procédé comprenant l'autre étape consistant à créer un vide partiel dans lequel se trouvent les solides particulaires chauffés par le rayonnement micro-ondes dirigé dans la cuve fermée de manière à favoriser la vaporisation des PFAS des solides particulaires.

3. Un procédé selon la revendication 2, dans lequel l'étape consistant à créer un vide partiel est effectuée en créant le vide partiel dans la cuve fermée alors que les solides particulaires s'y trouvent et dans lequel l'étape consistant à diriger un rayonnement micro-ondes prévoit de diriger une énergie micro-ondes dans les solides particulaires en dessous du niveau de surface des solides particulaires dans la cuve fermée, de sorte qu'une proportion significative de l'énergie disponible est absorbée dans les solides particulaires avant que cette énergie n'atteigne l'espace gazeux au-dessus du niveau des solides particulaires, ce qui réduit ainsi le risque de formation de plasma dans l'espace gazeux au-dessus des solides particulaires.

4. Un procédé selon la revendication 2, dans lequel l'étape consistant à diriger un rayonnement micro-ondes est interrompue après une période de temps de chauffage, et dans lequel, essentiellement en même temps que ou après l'interruption de l'étape consistant à diriger le rayonnement micro-ondes, l'étape consistant à créer le vide partiel est effectuée de manière à créer le vide partiel dans la cuve fermée.

5. Un procédé selon la revendication 2, dans lequel, une fois que l'étape consistant à diriger un rayonnement micro-ondes pour chauffer les solides particulaires est terminée, les solides particulaires chauffés sont transférés de la cuve fermée à un étage d'extraction, permettant ainsi à d'autres solides particulaires contaminés d'être placés dans la cuve fermée pour y être chauffés, et dans lequel l'étape consistant à créer le vide partiel est effectuée pour favoriser la vaporisation des PFAS des solides particulaires dans l'étage d'extraction.

6. Un procédé selon l'une quelconque des revendications de 2 à 5, et comprenant en outre une étape d'inhibition du plasma effectuée pour inhiber la formation de plasma dans un espace gazeux au-dessus du niveau des solides particulaires au cours de l'étape consistant à diriger un rayonnement micro-ondes dans les solides particulaires en vue de les chauffer.

7. Un procédé selon la revendication 6, dans lequel l'étape d'inhibition du plasma prévoit d'effectuer le chauffage par micro-ondes des solides particulaires en deux stades consistant en (i) un stade de chauffage à plus haute puissance au cours duquel une énergie micro-ondes de plus haute puissance est appliquée aux solides particulaires alors que simultanément une pression à l'intérieur de la cuve supérieure à la pression atmosphérique (101 kPa) est maintenue, et (ii) un stade de chauffage par micro-ondes à plus faible puissance au cours duquel un niveau de plus faible puissance de rayonnement micro-ondes est appliqué aux solides particulaires et simultanément un vide partiel est créé dans la cuve dans laquelle le rayonnement micro-ondes de plus faible puissance est appliqué et au cours duquel les PFAS sont vaporisés pour leur extraction des solides particulaires.

8. Un procédé selon la revendication 7, dans lequel le stade de chauffage par micro-ondes à plus haute puissance et le stade de chauffage par micro-ondes à plus faible puissance sont alternés de manière à améliorer l'efficacité de l'extraction des PFAS par un chauffage à plus haute puissance et une extraction par vide plus élevé.

9. Un procédé selon l'une quelconque des revendications de 6 à 8, dans lequel l'étape d'inhibition du plasma prévoit essentiellement d'augmenter la quantité de gaz inerte, en particulier d'hélium ou de néon ou d'argon, dans l'atmosphère gazeuse mélangée avec et entourant les solides particulaires soumis au chauffage par rayonnement micro-ondes de manière à inhiber ainsi la création d'un plasma dans l'espace gazeux au-dessus du niveau des solides particulaires dans la cuve où le rayonnement micro-ondes a lieu.

10. Un procédé selon l'une quelconque des revendications de 1 à 9, dans lequel l'étape de traitement de la vapeur dans l'étage de traitement prévoit d'exposer la vapeur à un plasma à l'intérieur d'une zone de traitement, de sorte que les PFAS dans la vapeur entrant et passant à travers la zone de traitement sont soumis à une dissociation au moins partielle des molécules de PFAS.

11. Un procédé selon la revendication 10, dans lequel le plasma dans la zone de traitement est créé et/ou est maintenu en dirigeant vers la zone de traitement un rayonnement micro-ondes depuis un deuxième générateur de micro-ondes opérationnellement associé avec la zone de traitement.

12. Un procédé selon la revendication 10 ou 11, dans lequel les solides particulaires contaminés par des PFAS sont progressivement alimentés dans la cuve, soit par alimentation continue des solides particulaires, soit par alimentation intermittente de charges de solides particulaires, et les solides particulaires chauffés qui ont cédé les PFAS par vaporisation sont progressivement extraits de la cuve, de sorte que les solides particulaires se déplacent progressivement d'un emplacement d'alimentation en sol de la cuve à un emplacement d'extraction du sol de la cuve tout en étant exposés à un rayonnement micro-ondes, et dans lequel la chambre dans laquelle les solides particulaires sont irradiés présente une paroi ou fenêtre transparente aux micro-ondes à travers laquelle les solides particulaires sont exposés au rayonnement, l'enceinte comprenant un tube dans lequel les solides particulaires à traiter sont alimentés, le tube étant incliné et étant mis en vibration et/ou tourné de façon continue ou de façon intermittente de manière à ce que les solides particulaires descendent progressivement par gravité le long du tube incliné vers une sortie de celui-ci.

13. Un procédé selon la revendication 10 ou 11, dans lequel un lot de solides particulaires contaminés par des PFAS est placé dans la cuve fermée, et pendant l'irradiation par rayonnement micro-ondes, le lot est mélangé soit de façon intermittente soit de façon continue de manière à exposer le lot de solides particulaires essentiellement dans tout son volume au rayonnement micro-ondes pendant une période de vaporisation au cours de laquelle aucun autre solide particulaire n'est ajouté dans la cuve, et dans lequel la vapeur contenant les PFAS cédés par le lot est extraite de la cuve fermée pour être traitée en aval avant l'ouverture de la cuve et l'évacuation des solides particulaires traités qui s'y trouvent.

14. Un procédé selon l'une quelconque des revendications de 10 à 13, dans lequel les solides particulaires sont soumis à un processus de chauffage en deux stades comprenant :
un premier stade de préchauffage au cours duquel les solides particulaires sont chauffés afin de vaporiser l'eau contenue dans les solides particulaires et de sécher ainsi les solides particulaires jusqu'à une teneur en humidité prédéterminée, et
un deuxième stade de chauffage à plus haute énergie au cours duquel a lieu l'irradiation micro-ondes des solides particulaires ayant la teneur en humidité réduite pour favoriser la vaporisation des PFAS.

15. Un procédé selon l'une quelconque des revendications de 10 à 12, dans lequel la vapeur contenant les PFAS cédés par les solides particulaires est aspirée de la cuve pendant l'irradiation des solides particulaires dans la cuve, et dans lequel la vapeur contenant les PFAS est aspirée en continu de la cuve et transférée dans l'étage de traitement pendant le traitement des solides particulaires dans la cuve en créant une pression négative en aval de l'étage de traitement qui aspire ainsi les vapeurs de la cuve dans et à travers l'étage de traitement.
